# EUROPEAN PATENT SPECIFICATION

(11) **EP 0 697 278 B1**
(45) Date of publication and mention of the grant of the patent: **25.04.2001**
(21) Application number: 95112727.3
(22) Date of filing: 12.08.1995
(51) Int. Cl.: B32B 15/08, B32B 31/20

(54) **Liquid crystal polymer-metal laminate and a method of producing such a laminate**
Flüssigkristallin Polymer-Metall Verbundstoff und Verfahren zu seiner Herstellung
Stratifié de polymère cristallin-liquide et de métal et son procédé de fabrication

(30) Priority: 16.08.1994 US 291307
(43) Date of publication of application: 21.02.1996
(73) Proprietor: KURARAY CO., LTD., Kurashiki-City Okayama Prefecture 710 (JP)
(72) Inventor: Detlef, Frank, D-55130 Mainz (DE); Penoyer, John A., Greenville, South Carolina 29616 (DE); Jester, Randy D., Greer, South Carolina 29654 (DE); Onodera, Minoru, Kurashiki-city, Okayama (JP); Sato, Toshiaki, Kurashiki-City, Okayama (JP)
(74) Representative: von Kreisler, Alek, Dipl.-Chem.

(56) References cited:
- EP-A- 0 184 368
- EP-A- 0 502 190
- WO-A-89/01407
- WO-A-89/12547
- US-A- 4 863 767
- DATABASE WPI Section Ch, Week 8715 Derwent Publications Ltd., London, GB; Class A94, AN 87-106379 & JP-A-62 055 131 ( MITSUI TOATSU CHEM INC) , 10 March 1987

## Description

### 1) Field of the Invention

The present invention relates to a laminate of liquid-crystalline polymer and metal having characteristics suitable for the electronics industry. The present invention also relates to a process of producing the above-described laminate. In particular, the laminate can comprise a series of polymer-metal layers, as desired, for application as circuit boards, multi-layer printed boards, flexible interconnects, etc.

### 2) Prior Art

Liquid-crystalline polymers are well known as exemplified in the following U.S. Patents.

US-A-4,161,470 to Calundann discloses a polyester liquid-crystalline polymer formed primarily of reccurring 6-oxy-2-naphthoyl (15 - 35 % by weight) and p-oxybenzoyl (65 - 85 % by weight) moities. This polymer is commercially available under the tradename Vectran® from Hoechst Celanese Co.

Other liquid-crystalline polymers are known and described in "Polymer Liquid Crystals", by Ciferi, Krigbaum, and Meyer; published by Academic Press, 1981; and "High Modulus Polymers", by Zachariades, Porter, and Marcel; published by Dekker, Inc., 1988. Polymers of the type described therein are generally, but not limited thereto, fully aromatic polyesters, such as polyester carbonates, polyester amides, polyester imides, and similar polymers or block polymers.

US-A-4,737,398 to Ikenaga et al. describes a laminate of a liquid-crystalline polymer melt extruded onto a metallic film. Various metals such as copper, iron, aluminum, steel, magnesium, zinc, lead, etc. may be employed within the laminate. It is contemplated that the laminate film can be employed as a packaging material,sheet molding, electric wiring substrates, and body material.

US-A-4,966,807 to Harvey et al is primary directed to a film of biaxially oriented, liquid-crystalline polymer having a controllable coefficient of thermal expansion. Laminates of Vectran® and metal foils are described.

US-A-4,975,312 to Lusignea et al is directed to using biaxially oriented liquid-crystalline polymers for making printed wire boards. Such printed wire boards are produced from laminates of Vectran® and glass fabric/epoxy reinforcement.

German Patents DE-A-4,116,800 and DE-A-4,115,831 to Goldmann and Decker generally describe a method of laminating a film onto a fabric using a continuous high-pressure, high-temperature process, wherein the fabric includes a glass fiber mat.

US-A-4863767 discloses a method for bonding two metallic (see Example 3) substrates together by an adhesive composition, wherein the adhesive can be a sheet of a LCP. According to an embodiment the substrate(s) are coated with the LCP sheet in the molten state, followed by calendering, and pressing the coated substrates together at pressures of ca. 35 - 345 bar (500-5000 psi) and a temperature of at least the polymer softening temperature.

EP-A-0502190 discloses composite metal sheets having adhesive strength at a high temperature and dimensional stability of the LCP layer. The composite metal sheets may be used for electronic applications. The metal sheet(s) is preferably bonded by heat-compression with the use of a compression molding press or a roll at a temperature at which the polymer of the film melts.

EP-A-0184368 discloses a laminated composite sheet with good dimensional stability, which comprises a first layer of a melt-phase anisotropy exhibiting thermoplastic polymer, which polymer has been highly oriented in the direction of flow at the stage of extrusion or injection molding, and a second layer which can be a metallic film, these layers being laminated one over another in an alternate pattern. After lamination, the sheets so laminated are hot pressed. The polymer is a LCP and the LCP layer may contain additives and inorganic fibers.

WO-A-89/01407 discloses a composite metal/LCP laminate, the LCP layer optionally containing fillers, produced by contacting the metal layer surface with a polymer sheet at a pressure of 1 - 10000 psig, or preferably 300 - 2000 psig, at a temperature above the melt temperature of the polymer, and lamination time between 0.01 and 2 min. The composite laminate is characterized by cohesive and adhesive strength of the laminate layers. The copper and polymer layers are contacted in a hot press; alternatively continuous belt lamination can be carried out. The LCP is a LC polyarylester, such as Vectra or Xydar.

Heretofore no one has developed a laminate of liquid-crystalline polymer film and a metal having properties such that the laminate can meet the strictest requirements of the electronics industries. The desired properties include good high peel strength, good dimensional stability and other optional properties such as solder bath stability.

### SUMMARY OF THE INVENTION

The present invention relates to a process for producing a metallic laminate having a peel strength equal to or greater than 10 Newtons per linear centimeter in accordance with the Institute for Interconnection and Packaging Circuits (I.P.C) test 2.4.9, and a dimensional stability less than 0.2% in accordance with the Institute for Interconnection and Packaging Circuits (I.P.C) test 2.2.4 Method C, comprising:
a. laying one or more unixially or biaxially oriented liquid-crystalline polymer films over a sheet of metallic foil; and
b. bonding said film and said foil in an isobaric doublebelted press having a heating and a cooling zone at a pressure of between 5 to 100 bar and at a temperature greater than the melt point of the liquid-crystalline polymer and less than the temperature at which the polymer starts to degrade, and at a residence time in said press when said film is above its melt point temperature of between 0.5 to 1000 s.

Preferably, the peel strength is greater than 14 Newtons per centimeter and the dimensional stability is less than 0.05 %.
Further preferred embodiments of said process become evident from the dependent claims. Furthermore, the present invention relates to a liquid-crystalline polymer/metallic laminate comprising:
a. one or more layers of a liquid crystal polymer film; and
b. one or more layers of a metallic foil bonded to said film, wherein said laminate has a peel strength equal to or greater than 10 Newtons per linear centimeter and a dimensional stability less than 0.2%;
and is obtainable by the process as defined above.

The laminate of the present invention has certain advantages over known laminates of liquid-cystal polymers and metal foils, including those described in US-A-4,737,398. The chief advantages of the present invention are those of peel strength and good dimensional stability. Although the liquid-crystal polymer described in US-A-4,737,398 can be the same as employed in the present invention, the characteristics of good high peel strength and good dimensional stability are not inherent from the described laminate. Liquid-crystalline polymers of the present invention possess properties making them particularly suitable for use in the electronics industry. For example, these polymers have a low-moisture uptake such that there is no or very slight hygroscopic expansion and thus no change in electrical properties or dimensions. Metal laminates made from these polymers have good dimensional stability and peel strength over the temperature range of normal use for electronic applications. Additionally, no adhesive is necessary to bond the liquid-crystalline polymer to the conductive material, although an adhesive can be used. Lastly, these polymers will not burn easily and thus accidental overheating will not ignite the polymer.

To make the laminate of the present invention, the liquid-crystalline polymers employed herein are described in US-A-4,737,398. Specifically, components of the polyester may comprise:
1. one or more aromatic dicarboxylic acids and alicyclic dicarboxylic acids;
2. one or more aromatic diols, alicyclic diols and aliphatic diols;
3. one or more aromatic hydroxy-carboxylic acids;
4. one or more aromatic thiocarboxylic acids;
5. one or more aromatic dithiols and aromatic dithiophenols; and/or
6. one or more aromatic hydroxy hydroxylamines and aromatic diamines.

Thus, the liquid-crystalline polymers of the present invention may comprise:
(I) a polyester containing components 1 and 2;
(II) a polyester containing component 3 only;
(III) a polyester containing components 1, 2 and 3;
(IV) a polythiole ester containing component 4 only;
(V) a polythiole ester containing components 1 and 5;
(VI) a polythiole ester containing components 1, 4 and 5;
(VII) a polyester amide containing components 1, 3 and 6; or
(VIII) a polyester amide containing components 1, 2, 3 and 6.

Further, though not included in the category of the above-mentioned combinations of components, aromatic polyazomethyles may be cited as polymers capable of forming liquid-crystalline polymers. Typical examples of such polymers are: poly(nitrilo-2-methyl-1,4-phenylene-nitriloethylidene-1,4-phenylene ethylidene); poly(nitrilo-2-methyl-1,4-phenylene-nitrilomethylidene-1,4-phenylenemethylidene); and poly-(nitro-2-chloro-1,4-phenylene nitromethylidene-1,4-phenylene methylidene).

Although not included in the category of the above combinations of compounds, polyestercarbonates are included among liquid-crystalline polymers. These are composed essentially of 4-oxybenzoyl unit, dioxyphenyl unit, dioxycarbonyl unit, and terephthaloyl unit.

Enumerated below are chemical compounds which may constitute the components of above said items I) to VIII).

Among the aromatic dicarboxylic acids are such aromatic dicarboxylic acids as terephthalic acid, 4,4'-diphenyl dicarboxylic acid, 4,4'-triphenyl dicarboxylic acid, 2,6-naphthalene dicarboxylic acid, diphenyl ether-4,4-dicarboxylic acid, diphenoxyethane-4,4'-dicarboxylic acid, diphenoxybutane-4,4'-dicarboxylic acid, diphenylethane-4,4'-dicarboxylic acid, isophthalic acid, diphenylether-3,3'-dicarboxylic acid, diphenoxyethane-3-3'-dicarboxylic acid, diphenylethane-3,3'-dicarboxylic acid, and naphthalene-1,6-dicarboxylic acid; or the alkyl- or halogen-substituted of the above enumerated aromatic dicarboxylic acids, such as chloroterephthalic acid, dichloroterephthalic acid, bromoterephthalic acid, methyl terephthalic acid, dimethyl terephthalic acid, ethyl terephthalic acid, methoxy terephthalic acid, and ethoxy terephthalic acid.

Among the alicyclic dicarboxylic acids are such alicyclic dicarboxylic acids as trans-1,4-cyclohexane dicarboxylic acid, cis-1,4-cyclohexane dicarboxylic acid, and 1,3-cyclohexane dicarboxylic acid; or the alkyl-, alkoxy-, or halogen-substituted of the above enumerated alicyclic dicarboxylic acids, such as trans-1,4-(methyl)cyclohexane dicarboxylic acid, and trans-1,4-(1-chloro)cyclohexane dicarboxylic acid.

Among the aromatic diols are such aromatic diols as hydroquinone, resolcine, 4,4'-dihydroxy diphenyl, 4,4'-dihydroxy-triphenyl, 2,6-naphthalene diol, 4,4'-dihydroxy diphenyl ether, bis(4-hydroxyphenoxy) ethane, 3,3'-dihydroxy diphenyl, 3,3'-dihydroxy diphenyl ether, 1,6-naphthalene diol, 2,2-bis(4-hydroxyphenyl) propane, and 2,2-bis(4-hydroxyphenyl) methane; or the alkyl-, alkoxy-, or halogen-substituted of the above enumerated aromatic diols, such as chlorohydroquinone, methyl hydroquinone, 1-butylhydroquinone, phenyl hydroquinone, methoxy hydroquinone, phenoxy hydroquinone, 4-chloro resolcine, and 4-methyl resolcine.

Among the alicyclic diols are such alicyclic diols as trans-1,4-cyclohexane diol, cis-1,4-cyclohexanediol, trans-1,4-cyclohexane dimethanol, cis-1,4-cyclohexane dimethanol, trans-1,3-cyclohexane diol, cis-1,2-cyclohexane diol, and trans-1,3-cyclohexane dimethanol; or the alkyl-, alkoxy-, or halogen-substituted of the above enumerated alicyclic diols, such as trans-1,4-(1-methyl) cyclohexane diol, and trans-1,4-(1-chloro) cyclohexane diol.

Among the aliphatic diols are such straight-chain or branched aliphatic diols as ethylene glycol, 1,3-propane diol, 1,4-butane diol, and neopentyl glycol.

Among the aromatic hydroxy carboxylic acids are such aromatic dihydroxy carboxylic acids as 4-hydroxy benzoic acid, 3-hydroxy benzoic acid, 6-hydroxy-2-naphthoic acid, and 6-hydroxy-1-naphthoic acid; or the alkyl-, alkoxy-, or halogen-substituted or aromatic hydroxy carboxylic acids, such as 3-methyl-4-hydroxy benzoic acid, 3,5-dimethyl-4-hydroxy benzoic acid, 2,6-dimethyl-4-hydroxy benzoic acid, 3-methoxy-4-hydroxy benzoic acid, 3,5-dimethoxy-4-hydroxy benzoic acid, 6-hydroxy-5-methyl-2-naphthoic acid, 6-hydroxy-5-methoxy-2-naphthoic acid, 3-chloro-4-hydroxy benzoic acid, 2-chloro-4-hydroxy benzoic acid, 2,3-dichloro-4-hydroxy benzoic acid, 3,5-dichloro-4-hydroxy benzoic acid, 2,5-dichloro-4-hydroxy benzoic acid, 3-bromo-4-hydroxy benzoic acid, 6-hydroxy-5-chloro-2-naphthoic acid, 6-hydroxy-7-chloro-2 naphthoic acid, and 6-hydroxy-5,7-dichloro-2-naphthoic acid.

Among the aromatic mercapto carboxylic acids are 4-mercaptobenzoic acid, 3 mercaptobenzoic acid, 6-mercapto-2-naphthoic acid, and 7-mercapto-2-naphthoic acid.

Among the aromatic dithiols are benzene-1,4-dithiol, benzene-1,3-dithiol, 2,5-naphthalene-dithiol, and 2,7-naphthalene-dithiol.

Among the mercaptophenols are 4-mercaptophenol, 3-mercaptophenol, 6-mercaptophenol, and 7-mercaptophenol.

Among the aromatic hydroxyamines and aromatic diamines are 4-aminophenol, N-methyl-4-aminophenol, 1,4-phenylene diamine, N-methyl-1,4-phenylene diamine, N,N'-dimethyl-1,4-phenylene diamine, 3-aminophenol, 3-methyl-4-aminophenol, 2-chloro-4-aminophenol, 4-amino-1-naphthol, 4-amino-4'-hydroxy diphenyl, 4-amino-4'-hydroxydiphenyl ether, 4-amino-4'-hydroxydiphenyl methane, 4-amino-4'-hydroxydiphenyl sulfide, 4,4'-diamino-phenyl sulfide (thiodianiline), 4,4'-diaminophenyl sulfone, 2,5-diaminotoluene, 4,4"-ethylene dianiline, 4,4'-diaminophenoxy ethane, 4,4'-diaminophenol methane (methylene diamine), and 4,4'-diaminodiphenyl ether (oxydianiline).

Among aforesaid polymer groups I) to VIII) composed of ingredients selected from among the above enumerated compounds may be some which are not capable of exhibiting anisotropic melt-phase forming characteristics, depending upon the types of the components, their proportions in the polymer, and their sequential distribution. It is noted that polymers used for the purpose of the invention are limited to those of the above enumerated which exhibit melt-phase anisotropy.

These polymers can easily be made as described in US-A-4,161,470 and US-A-4,737,398 and some can be purchased under the tradename Vectran® from the Hoechst Celanese Co., Somerville, N.J., U.S.A.

The metals foils useful for the present invention include metallic alloys or metal-like compositions. In the class of metals is copper, silver, gold, iron, steel, including stainless steel, chromium steel, zinc, brass, magnesium, nickel, molybdenum, copper/nickel, nickel/chromium, silicone-carbide compositions, and graphite, or mixtures of these for example.

Laminates can be formed by two different processes. The first process is described in Examples 1 to 8 of US-A-4,737,398. In this process, pellets of liquid-crystalline polymer are melt extruded through a "T' die extruder onto a metallic foil. Extruded liquid-crystalline polymer described in these examples has good mechanical strength in one direction only (see the Comparative Examples of US-A-4,737,398) and thus the metal foil is designed to provide a more balanced mechanical strength (see Examples 1 to 8 and Table 1 of US-A-4,737,398). This process does not produce acceptable peel strength and dimensional stability, particularly for very thin laminates. Additionally, it is very desirable to heat the metallic foil slightly below to slightly above (± 15 °C) the melt point of the liquid crystalline polymer to achieve bonding. At these temperatures the metallic foil may oxidize (unless an inert gas is employed, which is very expensive), making the laminate unsuitable for electrical applications. Moreover, the extrusion process makes it very difficult to produce complex structures such as those described hereinafter.

The second process melt extrudes a liquid-crystalline polymer onto a chill roll and stretch orients the film in one or more directions or extrudes the film from an annular die followed by orientation in one or more directions, as are known in forming polyester film. Thereafter, one or more pieces of the liquid-crystalline film can be overlaid on one or more pieces of a metallic foil, and subject to heat and pressure sufficient to bond the various layers into a laminate to yield structures, where
A = metal
B = polymer film
C = fabric,
such as A/B, A/B/A or B/A/B structures, A/B/A/B or B/A/B/A structures, A/B/C/B/A, A/B/B'/C/B/A, A/B/B', etc.

When a laminate is produced that has polymer film on one or both outer sides, it may be desirable to employ a release film between the polymer film and the platten of the press, so that no sticking of the polymer film to the platten occurs. Any release film, which does not interfere with or alter the characteristics of the polymer or laminate, would be suitable. The release film can be a polyimide, a fluoropolymer, or a release coated metal foil such as aluminum, for example.

Once the oriented liquid-crystalline polymer film (or films) is laid over the metal foil, the film is then bonded to the foil at a pressure between 5 to 100 bar at a temperature of more than the melt temperature of the polymer but less than its degradation temperature. At the temperature and pressure referenced above, the liquid-crystalline polymer undergoes a melt-phase enabling it to bond securely to the metallic foil, with a peel strength of equal to or greater than 10 N/cm and a dimensional stability of less than 0.2 %.

The process according to the present invention is a continuous process in which one or more rolls of oriented liquid-crystalline polymer film is laid over one or more sheets of metallic foil, with or without one or more rolls of reinforcing fabric and bonded thereto by means of high pressure and temperature with a double belted press . The residence time in the press when the liquid-crystalline polymer is above its melting point is 0.5 to 1000 s. Prior art processes do not discuss this particular method of bonding a metallic foil in the form of a sheet to a liquid-crystalline polymer. The typical double belt press may have a heating and cooling zone of 1.4 meters wide by 2.0 meters long. Double belt presses are known per se, for example through Kurt Held GmbH, Trossingen-Schura, Federal Republic of Germany.

Of course, the amount of pressure and temperature applied to the liquid-crystalline polymer film and the metallic foil depends upon the type of polymer employed and upon the metallic foil employed and the physical and dimensional properties of each, along with the operational, physical and dimensional properties of the press. For example, the melt point of the polymer would be an important feature along with the thickness of the polymer, the thickness of the metallic foil as well as its ability to transfer heat, and of course how thick the multilayer structure is. Also, the heat transfer characteristics of the platten (of the press), its size and thickness, residence time of the laminate in the press, etc. are very important. For example, with a liquid-crystalline polymer formed primarily of recurring 6-oxy-2-naphthoyl and p-oxybenzoyl moities (27 % by weight 6-oxy-2-naphthoyl, 73 % by weight p-oxybenzoyl), the temperature should be below approximately 350 °C and a particularly preferred temperature range is approximately 280 °C to 320 °C. While employing this particular liquid-crystalline polymer along with a copper metallic foil having an average thickness of 50 µm, the pressure to be applied to such an A/B laminate should be in the range of from 10 to 40 bar.

The liquid-crystalline polymers may include fillers and other additives well known in the art. Such fillers and additives may include, for example, organic or inorganic particles, plasticizers, light and weathering stabilizers, antistatic agents, ultraviolet absorbing agents, dyes, pigments, viscosity agents and lubricants.

In forming a laminate, it may be desirable to use a reinforcement fabric or material particularly when additional stiffness or dimensional stability is required. The reinforcement material can be, for example, a woven or non-woven fabric, such as carbon fabric, aramid fabric, glass fiber fabric, polyamide fabric, LCP fabric, quartz fabric, or mixtures of them, as is known in the art.

The nominal metallic foil thickness can be from 2 µm to 500 µm. The liquid-crystalline film can be from 10 µm to 2500 µm thick. For printed circuit boards, the film is generally from 25 µm to 750 µm thick. Copper foil employed in printed circuit boards is generally between 5 µm to 100 µm thick. Typically, reinforcement fabric is about 40 µm thick.

### Experimental Conditions

The following tests were employed on the laminates in the subsequent examples. The brief description of these tests is more clearly set forth by reference to the Test Method Manual of the I.P.C., IPC-TM-650.

### Peel Strength

Peel strength is determined in accordance with the Institute for Interconnection and Packaging Electronic Circuits (I.P.C.) test 2.4.9. The test determines the bond strength between copper foil and flexible dielectric support material.

A test specimen 22.86 cm (9 inches) long and 1.27 cm (½ inches) wide is cut from a laminate (a minimum of 4 specimens), 2 from the machine direction and 2 from the transvers direction. The testing machine is a power driven testing machine of the crosshea autographic type having a constant drive speed, such as a THWING ALBER machine.

The specimens are conditioned for 24 hours at 23 ± 2 °C and 50 ± 5 % relative humidity. After attaching the specimen with the mechanical clamps, the foil is peeled from the flexible dielectric support material at a crosshead speed of 5.08 cm/minute (2 inches/minute) for the entire sample. The peel strength is computed as the average force divided by the specimen width.

### Dimensional Stability

Dimensional stability is determined in accordance with I.P.C. 2.2.4 Method C averaging at least 5 measurements. The test determines the thermal gradien dimensional charges of a plastic dielectic, which is metal clad. A test specimen is at least 26.67 x 29.29 cm (10 ½ by 11 ½ inches) with the machine direction being the longer dimension. Scribe 0.005 inch wide lines or punch holes on the specimen at corner points. Condition the specimen for 24 hours at 23 ± 2 °C and 50 ± 5 % relative humidity. Measure separation of lines between corresponding lines, or separation between holes. Chemically erode 100 % of the metal away at 43 ± 5 °C using an etchant having no detrimental effect on the dielectric properties. Wash and dry. Place unconstrained, etched, conditioned and measured specimen in an oven at a temperature of 150 ± 2 °C for 30 ± 2 minutes. Stabilize the specimen at 23 ± 20 °C at 50 ±5 % relative humidity for a minimum of 24 hours. Remeasure separation of lines, or holes. The difference of the final measurements minus the initial measurements, divided by the initial measurements, times 100 yields the percent of change due to stress relaxation.

### Tensile Strength

This test determines the tensile strength of the specimens in accordance with I.P.C. 2.4.19. Each specimen is 15.24 cm by 1.27cm (6 inches by ½ inch) wide. A minimum of 10 specimens, 5 from the machine direction (MD) and five from the transverse direction (TD) are necessary. A THWING ALBERT tensile strength machine can be employed with the axis of the specimen coinciding with the center line of the gripping heads of the machine. Each specimen is conditioned for 24 hours at 23 ± 2 °C at 50 ± 5 % relative humidity. The gripping heads are initially set to 10.16 cm (4 inches) and the rate of grip separation is 5.08 cm (2 inches) per minute. Once the machine is started, it will record load versus extension. Tensile strength shall be the average of the specimens in the MD direction (and the same for the TD direction), each specimen tensile strength being calculated by dividing the load at break by the original cross sectional area.

### Solder Bath

This test determines if the laminate can withstand specific thermal conditions, as described in I.P.C. 2.4.13. Four specimens, each 5.08 cm (2 inches) square were employed. For double clad laminate, the copper foil shall be etched from the non-test side of each specimen. Condition each specimen for 24 hours at 23 ± 2 °C and 50 ± 5 % relative humidity. Dip each specimen in molten flux for 5 to 10 seconds, then vertically drain for 60 seconds. Attach each specimen to the bottom of the cork float, metallic foil side down (away from cork surface) and hold float bottom surface just below the surface of the SN-60 molten solder maintained at 260 ± 5 °C for 10 seconds, while agitating the specimens from side to side during immersion. Then remove and let excess solder drain. Examine each specimen for blistering, delamination or measling. These same procedures are also repeated except that the molten solder bath was maintained at 288 °C.

For the examples set forth subsequently, Vectran® A or C were employed. Vectran® A comprises 73 mole % of p-oxybenzoyl (4-hydroxybenzoic acid) and 27 mole % of 6-oxy-2-naphthoyl (2,6-hydroxynaphthalic acid) available from the Hoechst Celanese Co., Somerville, N.J., U.S.A. Vectran® C comprises 80 mole % of p-oxybenzoyl and 20 mole % of 6-oxy-2-naphthoyl also available from the Hoechst Celanese Co. All uniaxially oriented film is oriented only in the MD direction. The type of copper foil employed is an electro-deposited foil in which a drum is slightly dipped into a galvanic copper bath whereby copper is deposited on the surface of the drum, thus forming a foil, and then removed from the drum as is known in the art. The reinforcement fabric is type 106 woven glass fabric having a thickness of approximately 40 µm (microns).

All laminate sizes for double belt press were 45 cm wide. All the examples employ Vectran® A or C film. Because the melting temperature is about 282 °C and 312 °C, respectively, all laminates of the present invention using Vectran®-C film satisfy the requirements for a good solder bath laminate, while Vectran®-A film satisfies only the 260 °C solder bath conditions.

The following examples are presented to further illustrate the invention. However, these examples are not to be construed to limit the scope of the invention.

### Example 1 (Peel Strength)

### Sample 1

Using a double belt press, both sides of a Vectran® film were melt laminated to copper foil.

| General Conditions: | |
|---|---|
| Vectran® type | A-resin - uniaxially oriented |
| Vectran® thickness | 125 µm |
| copper type | ED |
| copper thickness | 35 µm |
| | |
| entrance zone temperature | 220 °C |
| heating zone temperature | var. |
| cooling zone temperature | 100 °C |
| belt speed | 5 m/min |
| lamination pressure | 25 bar |

| Results: | |
|---|---|
| heating zone temperature [° C] | peel strength [N/cm] |
| 260 | 11 |
| 280 | 14 |
| 300 | 16 |
| 320 | 20 |
| 340 | 25 |

This sample demonstrates that the desirable higher peel strengths are related to higher heating zone temperatures.

### Sample 2

| General Conditions: | |
|---|---|
| Vectran type® | A-resin - uniaxially oriented |
| Vectran thickness® | 125 µm |
| copper type | ED |
| copper thickness | 35 µm |
| | |
| entrance zone temperature | 220 °C |
| heating zone temperature | 340 °C |
| cooling zone temperature | 100 °C |
| belt speed | var. |
| lamination pressure | 25 bar |

| Results: | |
|---|---|
| Belt Speed [meter/minute] | peel strength [N/cm] |
| 1 | 14 |
| 5 | 25 |
| 9 | 17 |

This sample demonstrates that if the residence time is too short, the peel strength can be adversely affected.

### Example 2 (Anisotropic)

### Sample 1

Using a double belt press, both sides of a Vectran® film were melt laminated to copper foil. Then the copper laminate is etched away (in a manner described in I.P.C. 2.2.4) leaving only the Vectran® film. Anisotropic ratio is the ratio of tensile modulus in the MD divided by the tensile modulus in the TD. Balanced films have an anisotropic ratio of 1.0.

| General Conditions: | |
|---|---|
| Vectran type® | A-resin - uniaxially oriented |
| Vectran thickness® | 50 µm |
| copper type | ED |
| copper thickness | 35 µm |
| | |
| entrance zone temperature | 220 °C |
| heating zone temperature | var. |
| cooling zone temperature | 100 °C |
| belt speed | 3 m/min |
| lamination pressure | 15 bar |

| Results: | |
|---|---|
| heating zone temperature [°C] | anisotropic ratio |
| 260 | 10 |
| 280 | 8 |
| 300 | 7 |
| 320 | 3 |
| 340 | 1 |

Generally, balanced films have the best dimensional stability. This example shows that starting with a uniaxially oriented film you can obtain a balanced film by controlling the heating zone temperature.

### Sample 2

| General Conditions: | |
|---|---|
| Vectran® type | C-resin - uniaxially oriented |
| Vectran® thickness | 50 µm |
| copper type | ED |
| copper thickness | 35 µm |
| entrance zone temperature | 220 °C |
| heating zone temperature | 340 °C |
| cooling zone temperature | 100 °C |
| belt speed | var. |
| lamination pressure | 15 bar |

| Results: | |
|---|---|
| belt speed [m/min] | anisotropic ratio |
| 3 | 1 |
| 5 | 2 |
| 7 | 4 |

This sample shows that the residence time of the laminate in the press effects the anisotropic nature of the film. Shorter residence times (faster belt speed) result in poor anisotropic ratios.

### Example 3 (Dimensional Stability)

Using a double belt press, both sides of a Vectran® film were melt laminated to copper foil.

| General Conditions: | |
|---|---|
| Vectran® type | C-resin - uniaxially oriented |
| Vectran® thickness | 50 µm |
| copper type | ED |
| copper thickness | 18 µm |
| entrance zone temperature | 220 °C |
| heating zone temperature | 340 °C |
| cooling zone temperature | var. |
| belt speed | 1 m/min |
| lamination pressure | 27.5 bar |

| Results: | |
|---|---|
| cooling zone temperature [° C] | dimensional stability [%] |
| 210 | 0.20 |
| 220 | - 0.24 |
| 237 | - 0.08 |
| 250 | - 0.04 |
| 255 | - 0.03 |

This example shows that the cooling zone temperature relates to the dimensional stability, with higher cooling zone temperatures yielding better dimensional stability.

### Example 4 (Homogeneity)

### Sample 1

Using a double belt press, both sides of a Vectran® film were melt laminated to copper foil. After removing the copper, a transparency pattern (MD-stripes) is observed.

| General Conditions: | |
|---|---|
| Vectran® type | C-resin - biaxially oriented |
| Vectran® thickness | 30 µm |
| copper type | ED |
| copper thickness | 18 µm |
| | |
| entrance zone temperature | 220 °C |
| heating zone temperature | var. |
| cooling zone temperature | 100 °C |
| belt speed | 3 m/min |
| lamination pressure | 35 bar |

| Results: | |
|---|---|
| heating zone temperature [° C] | stripe pattern |
| 300 | no |
| 320 | weak |
| 340 | strong |

A dependency of this stripe pattern on the heating zone temperature has been observed.

### Sample 2

| General Conditions: | |
|---|---|
| Vectran® type | C-resin - uniaxially oriented |
| Vectran® thickness | 50 µm |
| copper type | ED |
| copper thickness | 18 µm |
| | |
| entrance zone temperature | 220 °C |
| heating zone temperature | 350 °C |
| cooling zone temperature | var. |
| belt speed | 3 m/min |
| lamination pressure | 35 bar |

| Results: | |
|---|---|
| cooling zone temperature [° C] | stripe pattern |
| 100 | strong |
| 200 | strong |
| 250 | weak |
| 270 | no |

A dependency of this stripe pattern on the cooling zone temperatures has been observed.

### Example 5 (Reinforcement)

### Sample 1

Using a double belt press, both sides of a Vectran® film were melt laminated to copper foil. After removing the copper, the mechanical properties were measured.

| General Conditions: | |
|---|---|
| Vectran® type | A-resin - uniaxially oriented |
| Vectran® thickness | 100 µm |
| copper type | ED |
| copper thickness | 35 µm |
| reinforcement | glass fabric type 106 optional |
| | |
| entrance zone temperature | 220 °C |
| heating zone temperature | 320 °C |
| cooling zone temperature | 100 °C |
| belt speed | 5 m/min |
| lamination pressure | 15 bar |

| Results: | |
|---|---|
| reinforcement | tensile strength mega-pascals [MPa] |
| none | 140 |
| glass fabric | 250 |

An improvement of mechanical properties by incorporating reinforcement fabric in the Vectran® film was observed.

### Sample 2

Using a double belt press, both sides of a Vectran® film were melt laminated to copper foil.

| General Conditions: | |
|---|---|
| Vectran® type | C-resin - uniaxially oriented |
| Vectran® thickness | 100 µm |
| copper type | ED |
| copper thickness | 18 µm |
| reinforcement | glass fabric type 106 optional |
| | |
| entrance zone temperature | 220 °C |
| heating zone temperature | 350 °C |
| cooling zone temperature | 150 °C |
| belt speed | 3 m/min |
| lamination pressure | 30 bar |

| Results: | |
|---|---|
| reinforcement | dimensional stability [%] |
| none | 0.05 |
| T 106 woven glass fabric | 0.021 |

An improvement in dimensional stability by incorporating reinforcement fabric in the Vectran® film was observed.

### Example 6 (Heat Sealing Layer)

Using a double belt press, multiple layers of different types of Vectran® have been melt laminated together.

| General Conditions: | |
|---|---|
| structure | ABA |
| Vectran® A-type | A-resin, uniaxially |
| Vectran® A-thickness | 50 µm |
| Vectran® B-type | C-resin, uniaxially |
| Vectran® B-thickness | 50 µm |
| entrance zone temperature | 220 °C |
| heating zone temperature | var. |
| cooling zone temperature | 100 °C |
| belt speed | 3 m/min |
| lamination pressure | 30 bar |

| Results: | |
|---|---|
| heating zone temperature [° C] | delamination |
| 260 | easy |
| 280 | easy |
| 300 | easy |
| 320 | no |
| 340 | no |

A dependency of delamination on the heating zone lamination temperature was observed. The melting point of Vectran® A is about 282 °C and the melting point of Vectran® C is about 312 °C. To obtain good bonded laminates it is important that all polymers achieve a melt phase state.

### COMPARATIVE Example 7

A laminate is prepared using a stack press by overlaying: a 50 µm thick film of Vectran® A; a type 106 40 µm thick glass fiber mat; another layer of Vectran® A (same thickness); and a 36 µm thick copper foil. The laminate was subjected to a pressure of 30 bar, at a temperature of 330 °C for 10 min. The temperature was increased from ambient and decreased from the 330 °C hold temperature at a rate of 10 °C per min. The original sample size was 45 x 45 cm. Good peel strength with cohesive failure inside the polymer film resulted.

### Example 8

Films of Vectran® A-resin were laminate to 35 µm ED copper foil utilizing a double belt press produced by Held GmbH. Lamination conditions were as follows:

### Sample 1

| | |
|---|---|
| Vectran® Type | A-resin uniaxially oriented |
| Vectran® Thickness | 50 µm |
| Copper Type | 35 µm ED |
| | |
| Entrance Zone Temperature | 220 °C |
| Heating Zone Temperature | 305 °C |
| Cooling Zone Temperature | 100 °C |
| Belt Speed | 2.5 meters/min. |
| Lamination Pressure | 27.5 Bar |
| | |
| Dimensional Stability (%) MD | 0.09 |
| Dimensional Stability (%) TD | 0.02 |
| Peel Strength | 19.4 N/cm |

### Sample 2

| | |
|---|---|
| Vectran® Type | A-resin biaxially oriented |
| Vectran® Thickness | 60 µm |
| Copper Type | 35 µm ED |
| | |
| Entrance Zone Temperature | 220 °C |
| Heating Zone Temperature | 275 progressing to 305 °C |
| Cooling Zone Temperature | 100 °C |
| Belt Speed | 6.5 meters/min. |
| Lamination Pressure | 27.5 Bar |
| | |
| Dimensional Stability (%) MD | 0.06 |
| Dimensional Stability (%) TD | 0.04 |
| Peel Strength | 14.7 N/cm |
| | |
| Dimensional Stability Test | I.P.C. 2.2.4 Method C (10X measurements) |
| | |
| Peel Strength after Solder Float | I.P.C. TM 650, Method C (260 °C Solder Temperature) |

### Comparative Example 9

Films of Vectran® A-resin were laminated to 35 µm ED copper foil by pressing the materials together in the nip formed between two rolls. The lamination was done at conditions of 280 °C, 30 kg/cm linear pressure, 3 meters/min. laminating speed. Examination of the dielectric and good adhesion indicated that a melt state was achieved in the lamination. Measured properties were as follows:

| Dielectric Material | *MD Dimensional Stability % | *TD Dimensional Stability % | Peel Strength N/cm pli |
|---|---|---|---|
| 50.8 µm (2mil) A-resin Uniaxially Oriented | 0.33 | - 0.74 | 11.1 (6.4) |
| 127 µm (5 mil) A-resin Uniaxially Oriented | 0.33 | - 0.92 | 11.1 (6.4) |
| 254 µm (10 mil) A-resin Uniaxially Oriented | 0.36 | - 0.87 | 11.0 (6.3) |
| 30.5 µm (1.2 mil) A-resin Biaxially Oriented | 0.24 | -0.17 | 10.7 (6.1) |

| | | | |
|---|---|---|---|
| * 5X measurements per I.P.C. Test Specs. | | | |

Although adequate peel strength was achieved, acceptable dimensional stability was not achieved. The laminates produced are not acceptable for producing printed wiring boards.

Thus it is apparent that there has been provided, in accordance with the invention, both a laminate and a method that fully satisfies the aims and advantages set forth above.

## Claims

1. A process for producing a metallic laminate having a peel strength equal to or greater than 10 Newtons per linear centimeter in accordance with the Institute for Interconnection and Packaging Circuits (I.P.C) test 2.4.9, and a dimensional stability less than 0.2% in accordance with the Institute for Interconnection and Packaging Circuits (I.P.C) test 2.2.4 Method C, comprising:
a. laying one or more unixially or biaxially oriented liquid-crystalline polymer films over a sheet of metallic foil; and
b. bonding said film and said foil in an isobaric double belted press having a heating and a cooling zone at a pressure of between 5 to 100 bar and at a temperature greater than the melt point of the liquid-crystalline polymer and less than the temperature at which the polymer starts to degrade, and at a residence time in said press when said film is above its melt point temperature of between 0.5 to 1000 s.

2. The process of claim 1, wherein the liquid-crystalline polymer is selected from the class consisting of:
a. a polyester containing one or more aromatic dicarboxylic acids and alicyclic dicarboxylic acids, and one or more aromatic diols, alicyclic diols and aliphatic diols;
b. a polyester containing one or more aromatic hydroxy-carboxylic acids;
c. a polyester containing one or more aromatic dicarboxylic acids and alicyclic dicarboxylic acids, one or more aromatic diols, alicyclic diols and aliphatic diols; and one or more of aromatic hydroxy-carboxylic acids;
d. a polythioester containing one or more aromatic thiocarboxylic acids; or
e. a polythioester containing one or more aromatic dicarboxylic acids and alicyclic dicarboxylic acids, and one or more aromatic dithiols and aromatic thiophenols;
f. a polythioester containing one or more aromatic dicarboxylic acids and alicyclic dicarboxylic acids, and one or more aromatic thiocarboxylic acids, and one or more aromatic dithiols and aromatic thiophenols;
g. a polyesteramide containing one or more aromatic dicarboxylic acids and alicyclic dicarboxylic acids, one or more aromatic hydroxy-carboxylic acids, and one or more aromatic hydroxylamines or aromatic diamines; and
h. a polyesteramide containing one or more aromatic dicarboxylic acids and alicyclic dicarboxylic acids, one or more aromatic dithiols, alicyclic diols and aliphatic diols, one or more aromatic hydroxy-carboxylic acids and one or more aromatic hydroxylamines and aromatic diamines.

3. The process of claim 2, wherein said liquid-crystalline polymer is 15 to 35 % by weight 6-oxy-2-naphthoyl and 65 to 85 % by weight p-oxybenzoyl.

4. The process of claim 2, wherein said liquid-crystalline polymer includes one or more additives.

5. The process of claim 4, wherein said one or more additives is selected from the class of plasticizers, light-fast and weathering stabilizers, antioxidants, ultraviolet absorbing agents, antistatic agents, flame-retardant agents, dyes, pigments, lubricants and viscosity reducing agents.

6. The process of claim 1, wherein said metallic foil is selected from the class of copper, silver, gold, aluminum, iron, steel, zinc, tin, brass, magnesium, nickel, molybdenum, copper/nickel alloy, nickel/chromium alloy, silicone carbide alloy, graphite, or mixtures of these.

7. The process of claim 1, wherein said liquid-crystalline polymer film comprises one or more reinforcing layers between one or more liquid-crystalline polymer layers.

8. The process of claim 1, wherein said liquid-crystalline polymer film comprises one or more woven or non-woven layers between one or more liquid-crystalline polymer layers.

9. The process of claim 1 wherein said liquid-crystalline polymer film comprises one or more layers of glass, carbon, aramid fiber between one or more liquid-crystalline polymer layers.

10. A liquid-crystalline polymer/metallic laminate comprising:
a) one or more layers of a liquid-crystalline polymer film; and
b) one or more layers of a metallic foil bonded to said film, wherein said laminate has a peel strength equal to or greater than 10 Newtons per linear centimeter in accordance with the Institute for Interconnection and Packaging Circuits (I.P.C) test 2.4.9, and a dimensional stability less than 0.2% in accordance with the Institute for Interconnection and Packaging Circuits (I.P.C) test 2.2.4 Method C;
and is obtainable by the process of any one of claims 1 to 9.

## Patentansprüche

1. Verfahren zur Herstellung eines metallischen Laminats mit einer Schälfestigkeit von gleich oder größer 10 N/cm gemäß dem Test 2.4.9 des Institute for Interconnection and Packaging Circuits (I.P.C.) und einer Maßhaltigkeit von weniger als 0,2 % gemäß dem Test 2,2,4 Methode C des Institute for Interconnection and Packaging Circuits (I.P.C.), umfassend:
a) das Anordnen eines oder mehrerer uniaxial oder biaxial orientierter, flüssigkristalliner Polymerfilme über einer Metallfolie; und
b) das Verbinden des Films und der Folie in einer isobaren Doppelriemenpresse, die eine Erwärmungszone und eine Kühlzone aufweist, bei einem Druck zwischen 5 und 100 bar und bei einer Temperatur, die größer ist als der Schmelzpunkt des flüssigkristallinen Polymers und geringer ist als die Temperatur, bei welcher die Zersetzung des Polymers beginnt, und mit einer Verweilzeit zwischen 0,5 und 1000 Sekunden in der Presse, während sich der Film oberhalb seiner Schmelzpunktstemperatur befindet.

2. Verfahren gemäß Anspruch 1, worin das flüssigkristalline Polymer aus der Klasse ausgewählt ist, bestehend aus:
a) einem Polyester, der eine oder mehrere aromatische Dicarbonsäuren und alicyclische Dicarbonsäuren und ein oder mehrere aromatische Diole, alicyclische Diole und aliphatische Diole enthält;
b) einem Polyester, der eine oder mehrere aromatische Hydroxycarbonsäuren enthält;
c) einem Polyester, der eine oder mehrere aromatische Dicarbonsäuren und alicyclische Dicarbonsäuren, ein oder mehrere aromatische Diole, alicyclische Diole und aliphatische Diole und eine oder mehrere aromatische Hydroxycarbonsäuren enthält;
d) einem Polythioester, der eine oder mehrere Thiocarbonsäuren enthält oder
e) einem Polythioester, der eine oder mehrere aromatische Dicarbonsäuren und alicyclische Dicarbonsäuren und ein oder mehrere aromatische Dithiole und aromatische Thiophenole enthält;
f) einem Polythioester, der eine oder mehrere aromatische Dicarbonsäuren und alicyclische Dicarbonsäuren und ein oder mehrere aromatische Thiocarbonsäuren und ein oder mehrere aromatische Dithiole und aromatische Thiophenole enthält;
g) einem Polyesteramid, das eine oder mehrere aromatische Dicarbonsäuren und alicyclische Dicarbonsäuren, ein oder mehrere aromatische Hydroxycarbonsäuren und ein oder mehrere aromatische Hydroxylamine oder aromatische Diamine enthält; und
h) einem Polyesteramid, das eine oder mehrere aromatische Dicarbonsäuren und alicyclische Dicarbonsäuren, ein oder mehrere aromatische Dithiole, alicyclische Diole und aliphatische Diole, eine oder mehrere aromatische Hydroxycarbonsäuren und ein oder mehrere aromatische Hydroxylamine und aromatische Diamine enthält.

3. Verfahren gemäß Anspruch 2, worin das flüssigkristalline Polymer zu 15 bis 35 Gew.-% 6-Oxy-2-naphthoyl und zu 65 bis 85 Gew.-% p-Oxybenzoyl ist.

4. Verfahren gemäß Anspruch 2, worin das flüssigkristalline Polymer ein oder mehrere Additive einschließt.

5. Verfahren gemäß Anspruch 4, worin das eine oder die mehreren Additive aus der Klasse der Weichmacher, der lichtechten und witterungsbeständigen Stabilisatoren, der Antioxidationsmittel, ultraviolettabsorbierenden Mittel, antistatischen Mittel, Flammverzögerungsmittel, Farbstoffe, Pigmente, Gleitmittel und viskositätsreduzierenden Mittel ausgewählt ist.

6. Verfahren gemäß Anspruch 1, worin die Metallfolie aus der Klasse von Kupfer, Silber, Gold, Aluminium, Eisen, Stahl, Zink, Zinn, Messing, Magnesium, Nickel, Molybdän, Kupfer/Nickel-Legierung, Nickel-Chrom-Legierung, Siliciumcarbid-Legierung, Graphit oder Mischungen derselben ausgewählt sind.

7. Verfahren gemäß Anspruch 1, worin das flüssigkristalline Polymer eine oder mehrere verstärkende Schichten zwischen einer oder mehreren flüssigkristallinen Polymerschichten umfasst.

8. Verfahren gemäß Anspruch 1, worin der flüssigkristalline Polymerfilm eine oder mehrere gewebte oder nichtgewebte Schichten zwischen einer oder mehreren flüssigkristallinen Polymerschichten umfasst.

9. Verfahren gemäß Anspruch 1, worin der flüssigkristalline Polymerfilm eine oder mehrere Schichten aus Glas-, Kohlenstoff- oder Aramidfaser zwischen einer oder mehreren flüssigkristallinen Polymerschichten umfasst.

10. Laminat aus flüssigkristallinem Polymer/Metall, umfassend:
a) eine oder mehrere Schichten eines flüssigkristallinen Polymerfilms; und
b) eine oder mehrere Schichten einer metallischen Folie, die an den Film gebunden ist, worin das Laminat eine Schälfestigkeit von gleich oder größer 10 N/cm gemäß dem Test 2.4.9 des Institute for Interconnection and Packaging Circuits (I.P.C.) aufweist, und eine Maßhaltigkeit von weniger als 0,2 % gemäß dem Test 2.2.4 Methode C des Institute for Interconnection and Packaging Circuits (I.P.C.) aufweist.

## Revendications

1. Procédé de production d'un stratifié métallique ayant une résistance au pelage égale ou supérieure à 10 newtons par cm linéaire selon l'essai 2.4.9 de l'*Institute for Interconnection and Packaging Circuits* (I.P.C.), et une stabilité dimensionnelle inférieure à 0,2 % selon l'essai 2.2.4, méthode C de l*'Institute for Interconnection and Packaging Circuits* (I.P.C.), comprenant:
a. le dépôt d'un ou plusieurs films de polymère cristal liquide orienté uniaxialement ou biaxialement sur une feuille métallique; et
b. la liaison dudit film et de ladite feuille dans une presse à double courroie isobare ayant une zone de chauffage et une zone de refroidissement sous une pression comprise entre 5 et 100 bars et à une température supérieure au point de fusion du polymère cristal liquide et inférieure à la température à laquelle le polymère commence à se dégrader, et pendant un temps de séjour dans ladite presse, une fois que la température dudit film est supérieure à son point de fusion, compris entre 0,5 et 1 000 secondes.

2. Procédé selon la revendication 1, dans lequel le polymère cristal liquide est choisi dans la classe constituée par:
a. un polyester contenant un ou plusieurs acides dicarboxyliques aromatiques et acides dicarboxyliques alicycliques, et un ou plusieurs diols aromatiques, diols alicycliques et diols aliphatiques;
b. un polyester contenant un ou plusieurs acides hydroxycarboxyliques aromatiques;
c. un polyester contenant un ou plusieurs acides dicarboxyliques aromatiques et acides dicarboxyliques alicycliques, un ou plusieurs diols aromatiques, diols alicycliques et diols aliphatiques, et un ou plusieurs acides hydroxycarboxyliques aromatiques;
d. un polythioester contenant un ou plusieurs acides thiocarboxyliques aromatiques; ou
e. un polythioester contenant un ou plusieurs acides dicarboxyliques aromatiques et acides dicarboxyliques alicycliques, et un ou plusieurs dithiols aromatiques et thiophénols aromatiques;
f. un polythioester contenant un ou plusieurs acides dicarboxyliques aromatiques et acides dicarboxyliques alicycliques, et un ou plusieurs acides thiocarboxyliques aromatiques, et un ou plusieurs dithiols aromatiques et thiophénols aromatiques;
g. un polyesteramide contenant un ou plusieurs acides dicarboxyliques aromatiques et acides dicarboxyliques alicycliques, un ou plusieurs acides hydroxycarboxyliques aromatiques, et une ou plusieurs hydroxylamines aromatiques ou diamines aromatiques; et
h. un polyesteramide contenant un ou plusieurs acides dicarboxyliques aromatiques et acides dicarboxyliques alicycliques, un ou plusieurs dithiols aromatiques, diols alicycliques et diols aliphatiques, un ou plusieurs acides hydroxycarboxyliques aromatiques et une ou plusieurs hydroxylamines aromatiques et diamines aromatiques.

3. Procédé selon la revendication 2, dans lequel ledit polymère cristal liquide est constitué de 15 à 35 % en masse d'unités 6-oxy-2-naphtoyle et de 65 à 85 % en masse d'unités p-oxybenzoyle.

4. Procédé selon la revendication 2, dans lequel ledit polymère cristal liquide comprend un ou plusieurs additifs.

5. Procédé selon la revendication 4, dans lequel lesdits additifs sont choisis dans la classe des plastifiants, des stabilisants à la lumière et aux intempéries, des antioxydants, des agents absorbant les ultraviolets, des agents antistatiques, des agents ignifuges, des colorants, des pigments, des lubrifiants et des agents réduisant la viscosité.

6. Procédé selon la revendication 1, dans lequel ladite feuille métallique est choisie dans la classe constituée par le cuivre, l'argent, l'or, l'aluminium, le fer, l'acier, le zinc, l'étain, le laiton, le magnésium, le nickel, le molybdène, un alliage cuivre/nickel, un alliage nickel/chrome, un alliage de carbure de silicium, du graphite, ou leurs mélanges.

7. Procédé selon la revendication 1, dans lequel ledit film de polymère cristal liquide comprend une ou plusieurs couches renforçantes entre une ou plusieurs couches de polymère cristal liquide.

8. Procédé selon la revendication 1, dans lequel ledit film de polymère cristal liquide comprend une ou plusieurs couches tissées ou non tissées entre une ou plusieurs couches de polymère cristal liquide.

9. Procédé selon la revendication 1, dans lequel ledit film de polymère cristal liquide comprend une ou plusieurs couches de fibres de verre, de carbone ou d'aramide entre une ou plusieurs couches de polymère cristal liquide.

10. Stratifié polymère cristal liquide/métal comprenant:
a. une ou plusieurs couches d'un film de polymère cristal liquide; et
b. une ou plusieurs couches d'une feuille métallique liées audit film,
ledit stratifié ayant une résistance au pelage égale ou supérieure à 10 newtons par cm linéaire selon l'essai 2.4.9 de l'*Institute for Interconnection and Packaging Circuits* (I.P.C.), et une stabilité dimensionnelle inférieure à 0,2 % selon l'essai 2.2.4, méthode C de l'*Institute for Interconnection and Packaging Circuits* (I.P.C.), et pouvant être obtenu par le procédé selon l'une quelconque des revendications 1 à 9.
